# FASCICULE DE BREVET EUROPEEN

(11) **EP 4 222 793 B1**
(45) Date de publication et mention de la délivrance du brevet: **14.08.2024**
(21) Numéro de dépôt: 21799082.9
(22) Date de dépôt: 30.09.2021
(51) Int. Cl.: H01M 4/04, C23C 16/56, C23C 16/455, C23C 16/40, H01M 4/525, H01M 4/505, H01M 4/1391, C23C 16/04

(54) **PROCÉDÉ DE FABRICATION D'UN MATÉRIAU LITHIÉ EN COUCHES MINCES**
VERFAHREN ZUR HERSTELLUNG EINES LITHIUM ENTHALTENDEN DÜNNSCHICHTMATERIALS
METHOD FOR MANUFACTURING A THIN-FILM LITHIATED MATERIAL

(30) Priorité: 01.10.2020 FR 2010047
(43) Date de publication de la demande: 09.08.2023
(73) Titulaire: Centre national de la recherche scientifique, 75016 Paris (FR); Université de Lille, 59800 Lille (FR); Centrale Lille Institut, 59650 Villeneuve-d'Ascq (FR); Université Polytechnique Hauts-de-France, 59300 Aulnoy Lez Valenciennes (FR); Université d'Artois, 62000 Arras (FR); Nantes Université, 44000 Nantes (FR)
(72) Inventeur: LETHIEN, Christophe, 62138 VIOLAINES (FR); HALLOT, Maxime, 59220 DENAIN (FR); ROUSSEL, Pascal, 59000 LILLE (FR); BROUSSE, Thierry, 44240 LA CHAPELLE-SUR-ERDRE (FR)
(74) Mandataire: Brevalex
(86) Numéro de dépôt international: PCT/FR2021/051697
(87) Numéro de publication internationale: WO 2022/069842

(56) Documents cités:
- WO-A1-2009/084966
- WO-A1-2016/011412
- WO-A2-2011/002920
- DE-A1- 102017 203 910

## Description

La présente invention se rapporte à un procédé de fabrication d'un matériau lithié. Plus particulièrement, l'invention se rapporte à un procédé de fabrication d'un matériau contenant du lithium déposé en couches minces à la surface d'un substrat.

Dans l'état actuel de la technique, on connaît des procédés de formation de couches minces de matériaux sur des substrats de divers types, en particulier des procédés de production de couches de matériaux lithiés, c'est-à-dire contenant du lithium. Ces matériaux lithiés sont notamment utilisés dans des batteries, par exemple pour la formation d'électrodes ou de barrières électrolytiques, ou de tout autre dispositif électrique de stockage. Ces couches peuvent être déposées par une technique de dépôt de couches atomiques (technique nommée Atomic Layer Déposition en anglais et communément désignée par l'acronyme ALD) à partir de précurseurs, par une technique de dépôt chimique de couches atomiques en phase vapeur (technique nommée Chemical Vapor Déposition en anglais et communément désignée par l'acronyme ALCVD), ou encore par une technique de dépôt par épitaxie de couches atomiques (technique nommée Atomic Layer Epitaxy en anglais et communément désignée par l'acronyme ALE). En particulier, la technique ALD est une technique de dépôt de couches minces qui repose sur des réactions gaz-surface afin d'exposer la surface sur laquelle on souhaite déposer une couche d'un matériau à différents précurseurs chimiques successifs. Un tel procédé est par exemple décrit dans le document WO 2009/084966 A1.

Cependant, dans l'état actuel de la technique, il n'existe pas de procédé permettant de fabriquer un matériau lithié contenant des couches minces, c'est-à-dire des couches présentant des épaisseurs comprises entre 1 nm et 1 µm, constituées de matériaux complexes, électrochimiquement actifs, et qui soient, entre autres, homogènes et adaptées à se conformer aux reliefs plus ou moins complexes de la surface du substrat sur laquelle est déposé le matériau lithié.

Par relief complexe, au sens de la présente invention, on entend un substrat présentant des cavités, des tubes ou des piliers usinés dans ce substrat pour former un squelette en trois dimensions développant un rapport surface sur volume supérieur à 10.

Par ailleurs, il n'existe pas non plus, dans l'état de la technique, de procédé de fabrication permettant de fabriquer une couche d'électrode positive à base de matériau lithié adaptée à des batteries tridimensionnelles ou batterie 3D.

Par batterie tridimensionnelle ou batterie 3D, au sens de la présente invention, on entend une batterie présentant un motif définit par une épaisseur supérieure à 5 µm. Par exemple, comme batterie tridimensionnelle ou batterie 3D, on peut avoir une micro-batterie composée d'au moins six couches de matériaux déposées de façon conforme sur un substrat qui a été préalablement structuré pour former un tapis tridimensionnel développant une surface spécifique prédéfinie. Ces six couches sont les suivantes : une couche isolante, deux couches de collecteurs de courant, une couche d'électrode négative, une couche d'électrode positive. Ces deux couches d'électrodes sont séparées par un électrolyte solide. Ces six couches peuvent être éventuellement protégées avec une couche d'encapsulation supplémentaire qui préviendrait du vieillissement de la batterie 3D.

La présente invention a notamment pour objet de pallier tout ou partie des inconvénients susmentionnés.

À cet effet, selon un premier aspect, l'invention concerne un procédé de fabrication d'un matériau lithié sur un substrat, ledit matériau lithié comprenant plusieurs couches minces et ledit procédé comprenant les étapes suivantes:
a) placement dans une chambre de réaction d'un substrat constitué d'un matériau destiné à être utilisé dans une batterie,
c1) au moins un dépôt par couche atomique d'un précurseur d'un premier métal, choisi parmi le nickel, le manganèse, le cobalt, le chrome, le lanthane, le niobium, le vanadium, le fer, le titane et l'aluminium, à travers ladite chambre de réaction, sur au moins une partie d'une surface dudit substrat,
c2) au moins une purge de ladite chambre de réaction,
c3) au moins une diffusion d'une première espèce oxydante à travers ladite chambre de réaction pour obtenir une couche mince d'un oxyde du premier métal,
c4) au moins une purge de ladite chambre de réaction
f1) au moins un dépôt par couche atomique d'un précurseur de lithium à travers ladite chambre de réaction au-dessus de ladite couche mince d'un oxyde du premier métal pour former une couche mince lithiée,
f2) au moins une purge de ladite chambre de réaction,
ledit procédé étant caractérisé en qu'il comprend en outre, après l'étape f2), une étape g) de recuit de cristallisation à une température comprise entre 600 et 800 °C pendant une durée comprise entre 1 et 4 h pour obtenir un matériau lithié.

Par matériau destiné à être utilisé dans une batterie, au sens de la présente invention, on entend tout type de matériaux qui présente une tenue mécanique suffisante pour ne pas être mécaniquement altéré par les traitements thermiques usuellement mis en oeuvre dans les procédés de fabrication de batterie, qui soit inerte chimiquement et qui soit électrochimiquement stable sous l'effet de la température.

Selon ce premier aspect de l'invention, il est donc possible de fabriquer un matériau électrochimiquement actif qui comprend au moins une couche mince d'un oxyde d'un premier métal tel qu'indiqué précédemment et un couche mince lithiée sur un substrat. On peut ainsi déposer sur un substrat des matériaux complexes électrochimiquement actifs qui sont susceptibles de donner des performances électrochimiques adaptées aux batteries tridimensionnelles. Par exemple, il est possible, via ce procédé de fabrication, de fabriquer un matériau lithié contenant des couches minces qui soient, entre autres, homogènes sur une surface supérieure à 7.5 cm de côté.

Il est à noter que ce matériau lithié peut être utilisé, par exemple, dans des dispositifs de stockage électrochimiques. En particulier, un tel matériau lithié peut être utilisé pour la fabrication de batteries bidimensionnelles ou tridimensionnelles, en particulier de microbatteries tridimensionnelles, par exemple Li-ion, pour diverses applications. Dans les batteries bidimensionnelles ou tridimensionnelles, le substrat peut alors prendre la forme d'un objet en deux dimensions ou en trois dimensions.

Au sens de la présente invention, par objet en deux dimensions, on entend un objet plan, par exemple en silicium, ou tout objet permettant d'agir comme socle mécanique réceptacle de couches de matériaux pour la fabrication d'une batterie bidimensionnelle.

Au sens de la présente invention, par objet en trois dimensions, on entend un objet recouvert par un empilement de matériaux déposés, par exemple, sous la forme de couches minces par ALD. Par exemple, l'objet en trois dimensions peut présenter sur au moins l'une de ses surfaces, une structuration pouvant être réalisée par des techniques de gravure de la microélectronique ou des techniques de croissances de micro/nano objets.

Aussi, avec un tel procédé selon l'invention, lorsque le substrat est microstructuré, c'est-à-dire lorsque le substrat présente sur au moins une de ses surfaces une certaine rugosité de surface, le matériau lithié déposé se conforme à cette miscrostructure de sorte qu'il est donc possible de former aisément un matériau lithié qui épouse parfaitement la microstructure du substrat de sorte à obtenir un matériau homogène et présentant une épaisseur équivalente sur toute la surface sur laquelle est formé le matériau.

En particulier, un substrat microstructuré présente une surface spécifique plus importante qu'un substrat plan (c'est-à-dire non microstructuré). La surface d'un substrat peut par exemple être augmentée par la disposition de microstructures présentant un rapport d'aspect élevé à la surface dudit substrat. Le rapport d'aspect d'une microstructure correspond par exemple au rapport de sa dimension longitudinale par sa plus petite dimension transversale (par exemple la plus petite distance transversale entre deux microstructures disposées consécutivement sur le substrat).

Par exemple, comme substrat microstructuré, on peut avoir des substrats comprenant des microstructures du type tranchées, piliers et canaux, ou aussi des microstructures telles qu'enseignées dans la publication WO2015052412. Il est également à noter que le substrat peut être usinable par des techniques de microfabrication et doit être résistant aux traitements thermiques appliqués lors de la mise en oeuvre de son procédé de fabrication, par exemple lors des étapes de dépôt et de recuit.

Par exemple, comme substrat, on peut avoir un substrat choisi parmi les substrats en silicium, en SiO₂, en Al₂O₃, en Ti, en verre, en Kapton ^{®}. Par ailleurs, le substrat peut être flexible ou rigide.

Il est à noter que le précurseur du premier métal peut se présenter sous forme de liquide ou de poudre. Par exemple, le précurseur du premier métal peut être choisi parmi les précurseurs suivants : FeCl₂, FeCp₂, Fe(thd)₃, La(thd)₃, CoCp₂, MnCp₂, Mn(thd)₃, NiCp₂, TiCl₄, NbOEt₅, Cr(OCl)₂, sans pour autant se limiter à ces derniers.

Il est à noter que l'étape c3) de diffusion d'une première espèce oxydante permet de rompre les liaisons chimiques des éléments se trouvant en surface après la mise en oeuvre de l'étape c1). Cette première espèce oxydante est choisie en fonction de la force des liaisons chimiques des éléments impliquées. Par exemple, l'ozone est de préférence utilisé pour favoriser l'oxydation du manganèse et ainsi assurer la formation de MnO₂.

De préférence, la couche mince d'un oxyde du premier métal présente une épaisseur comprise entre 5 et 15 nm. Cette première couche peut également de préférence être déposée à une vitesse comprise entre 0.5 et 1 A par cycle ALD.

Il est également à noter que le précurseur de lithium peut se présenter sous forme de poudre. Par exemple, le précurseur de lithium peut être du LiOtBu, sans pour autant se limiter à ce dernier.

De préférence, la couche mince lithiée présente une épaisseur comprise entre 5 et 1000 nm. Cette première couche peut également de préférence être déposée à une vitesse comprise entre 0.5 et 1 A par cycle ALD.

Dans un mode particulier de réalisation, il est avantageux de fonctionnaliser le substrat pour faciliter les étapes ultérieures de dépôt, en particulier pour favoriser l'accroche sur le substrat des premières monocouches atomiques du précurseur du premier métal. Une telle fonctionnalisation permet également d'obtenir un substrat présentant des surfaces ne comprenant pas, ou très peu, d'éléments de pollution afin d'obtenir un état de surface propice aux réactions chimiques voulues lors des étapes suivantes de dépôt. Par conséquent, dans ce mode de réalisation, le procédé comprend en outre, entre les étapes a) et c1), au moins une étape b1) de fonctionnalisation du substrat, ladite étape b1) de fonctionnalisation consistant en une diffusion d'eau à travers ladite chambre de réaction et étant suivie d'une étape b2) de purge de ladite chambre de réaction d'eau.

De préférence, l'étape b1) de fonctionnalisation est mise en oeuvre à une température comprise entre 180 °C et 220 °C.

De préférence, le procédé comprend en outre, de préférence, une étape b3) d'une première itération des étapes b1) et b2) pendant n₁ fois, ladite étape b3) étant réalisée entre l'étape b2) et c1). Cette étape permet de fortement diminuer, voire d'éliminer totalement, toute pollution qui pourrait être présente sur les surfaces du substrat avant la mise en oeuvre des étapes ultérieures de dépôts.

Dans un mode particulier de réalisation, il est avantageux de fabriquer un matériau lithié comprenant au moins une couche mince d'un oxyde d'un premier métal et une couche mince d'un oxyde d'un deuxième métal plutôt qu'une unique couche mince d'un oxyde d'un premier métal. En effet, la présence, dans le matériau lithié, d'au moins deux couches minces d'un oxyde de deux métaux (de transition) différents permet d'obtenir un matériau lithié, électrochimiquement actif à plus haut potentiel par rapport à ceux actuellement utilisés. En particulier, il est ainsi possible d'utiliser un tel matériau lithié pour fabriquer une électrode positive d'une batterie tridimensionnelle opérant à haut potentiel, c'est-à-dire opérant à un potentiel supérieur à 4 V vs Li/Li⁺. Par conséquent, dans ce mode de réalisation, le procédé comprend en outre, entre les étapes c2) et f1) :
- au moins une étape d1) de dépôt par couche atomique d'un précurseur du deuxième de métal, choisi parmi le nickel, le manganèse, le cobalt, le chrome, le lanthane, le titane et l'aluminium, ou d'un précurseur de phosphate, à travers ladite chambre de réaction sur au moins une partie de ladite couche mince d'un oxyde du premier métal,
- au moins une étape d2) de purge de ladite chambre de réaction,
- au moins une étape d3) de diffusion d'une deuxième espèce oxydante à travers ladite chambre de réaction pour obtenir une couche mince d'un oxyde du deuxième métal ou de phosphate, et
- au moins une étape d4) de purge de ladite chambre de réaction.

Tout comme à l'étape c3) de diffusion d'une première espèce oxydante, l'étape d3) de diffusion d'une deuxième espèce oxydante permet de rompre les liaisons chimiques des éléments se trouvant en surface après la mise en oeuvre de l'étape d1). Cette deuxième espèce oxydante est choisie en fonction de la force des liaisons chimiques des éléments impliquées.

Il est à noter que la première espèce oxydante peut être identique à la deuxième espèce oxydante, mais pas nécessairement.

Par exemple, comme première et/ou deuxième espèces oxydantes, on peut donc citer l'ozone, l'eau, ou tout autre oxygène comprenant un composé gazeux tel que le CO₂. Des combinaisons de précurseurs d'oxygène peuvent également être utilisées, soit dans des étapes de diffusion d'espèce oxydante séparées ou simultanément dans la même étape de diffusion d'une première ou deuxième espèces oxydantes.

Il est également possible de mettre en oeuvre davantage d'étapes similaires aux étapes précitées d1) à d4) de sorte à obtenir des couches minces d'un oxyde de métaux supplémentaires. Par exemple, il est donc possible de cette manière d'obtenir les matériaux suivants : LiₓM1_{y}M2_{z}M3ₛOₜavec M1, M2 et M3 des métaux de transition parmi Ni, Mn, Co, Cr, Al tels que LiNi_{1/3}Mn_{1/3}Co_{1/3}O₂, LiₓNi_{y}Co_{z}AlₜO2 (avec y+z+t = 1).

De préférence, la couche mince d'un oxyde du deuxième métal ou de phosphate peut présenter une épaisseur comprise entre 5 et 15 nm. Cette couche peut également de préférence être déposée à une vitesse comprise entre 0.5 et 1 A par cycle ALD.

II est à noter que le précurseur du deuxième métal ou de phosphate est soit identique à celui déposé à l'étape c1) soit différent. Aussi, en formant des couches minces issues de précurseurs de métaux de transition différents, il est possible de former des matériaux lithiés ternaires, quaternaires ou quinaires par exemple.

II est à noter que le précurseur du deuxième métal ou de phosphate peut se présenter sous forme de liquide ou de poudre. Par exemple, le précurseur du deuxième métal ou de phosphate peut être choisi parmi les précurseurs suivants : La(thd)₃, CoCp₂, MnCp₂, Mn(thd)₃, NiCp₂, TiCl₄, Cr(OCl)₂, sans pour autant se limiter à ces derniers.

De préférence, le procédé comprend en outre une étape c5) d'une deuxième itération des étapes c1) à c4) pendant n₂ fois. Il est à noter que cette étape c5) est de préférence réalisée entre l'étape c4) et d1). Ainsi, il est possible d'obtenir une croissance homogène de l'oxyde du premier métal décrit par ces étapes c1) à c4) mais aussi de contrôler la stoechiométrie finale du matériau lithié que l'on souhaite fabriquer.

De préférence, le procédé comprend outre une étape d5) d'une troisième itération des étapes d1) à d4) pendant n₃ fois, ladite étape d5) étant réalisée entre l'étape d4) et f1). Ainsi, il est possible d'obtenir une croissance homogène de l'oxyde du deuxième métal décrit par ces étapes d1) à d4) mais aussi de contrôler la stoechiométrie finale du matériau lithié que l'on souhaite fabriquer.

De préférence, le procédé comprend en outre une étape e) d'une quatrième itération des étapes c1) à d4) pendant n₄ fois. Il est à noter que cette étape e) est de préférence réalisée entre l'étape d5) et f1). Ainsi, il est possible d'augmenter les épaisseurs de chacune des couches minces d'un oxyde du premier et deuxième métaux, donc de matériaux actifs, afin d'améliorer les performances d'une batterie tridimensionnelle qui comprendrait un tel matériau lithié.

Dans un mode particulier de réalisation, il est avantageux de fortement diminuer, voire éliminer, des espèces carbonées qui auraient été formées suite à la mise en oeuvre de l'étape f1) de dépôt par couche atomique du précurseur de lithium. Par conséquent, dans ce mode de réalisation, le procédé comprend en outre, entre les étapes f2) et g), au moins une étape f3) d'oxydation forcée de ladite couche mince lithiée, ladite étape f3) d'oxydation forcée consistant en la diffusion d'eau dans ladite chambre de réaction et étant suivie d'une étape f4) de purge de ladite chambre de réaction.

De préférence, l'étape f3) d'oxydation forcée est mise en oeuvre à une température comprise entre 180 °C et 220 °C.

Dans les étapes b1) et f3), l'eau est de préférence déionisée.

De préférence, le procédé comprend en outre une étape f5) d'une cinquième itération des étapes f1) à f4) pendant n₅ fois, ladite étape f5) étant réalisée entre l'étape f4) et g). Ainsi, il est possible d'augmenter l'épaisseur de la couche atomique du précurseur de lithium.

De préférence, n₅ se définit comme suit n₅ = 0.05 * (n₂ + n₃) * n₄. Par exemple, de cette façon, on peut optimiser le ratio des cycles ALD manganèse et nickel de manière à permettre la formation du matériau lithié tout en limitant la présence d'oxyde de lithium (NiO) et de Li₂MnO₃.

Aussi, en ajustant les valeurs de n₁ à n₅, il est possible d'obtenir différentes stoechiométries de matériaux comprenant du lithium, du nickel, du manganèse et de l'oxygène (ci-après désigné par matériau LNMO).

Par ailleurs, il est à noter que les étapes de purge consister à pulser un gaz inerte à travers la chambre de réaction après notamment chaque impulsion de précurseur, ou même en même temps que l'impulsion du précurseur. En variante, plusieurs impulsions de purge peuvent être effectuées entre chaque impulsion de précurseur. Les étapes de purge sont destinées à éliminer tous les réactifs n'ayant pas réagi, assurant ainsi que la fabrication du matériau lithié se déroule selon des réactions gaz-surface auto-limitantes. Aussi, la purge de la chambre de réaction peut être effectuée en faisant circuler un gaz de purge à travers la chambre ou, en variante, en évacuant la chambre en réduisant la pression. Les gaz de purge appropriés comprennent des gaz inertes tels que l'azote, l'argon, etc. bien que tout gaz ou mélange gazeux appropriés et ne réagissant pas avec la couche mince déposée de matériau contenant les précurseurs peuvent être pulsés.

Selon un deuxième aspect, l'invention concerne le matériau lithié susceptible d'être obtenu par un procédé tel que défini précédemment.

L'invention sera mieux comprise à la lecture de la description qui suit, faite uniquement à titre d'exemple, et en référence aux figures en annexe dans lesquelles :
[Fig 1] la figure 1 représente schématiquement un exemple de mise en oeuvre d'un procédé de fabrication selon l'invention ;
[Fig 2] la figure 2 représente une image TEM d'une vue en coupe du matériau de l'exemple 1 avant recuit obtenu selon un mode de réalisation de l'invention, sur ce matériau étant en outre déposée une couche d'alumine (Al₂O₃) de protection; et
[Fig 3] la figure 3 représente une image TEM d'une vue en coupe du matériau de l'exemple 1 après recuit obtenu selon un mode de réalisation de l'invention, sur ce matériau étant en outre déposée une couche d'alumine (Al₂O₃) de protection.

### DISPOSITIFS / PRODUITS

Dispositifs :
- la chambre de réaction : ALD reactor PICOSUN R200.

Produits :
- Substrat : BT Electronics, Siltronix (Si (100), 5 à 10 ohm.cm, 2" à 4", 1 face polie)
- Précurseurs ALD :
   _ de platine : Trimethyl)methylcyclopentadienylplatinum (IV), 99%, Merck, STREM Chemical
   _de phosphate : Trimethylphosphate, min. 97%, Merck, STREM Chemical
   _de lithium : Lithium t-butoxide, 98+%, Merck, STREM Chemical
   _d'alumine : Trimethylaluminum, min. 98%, Merck, STREM Chemical
   _ de nickel : Bis(cyclopentadienyl)nickel, 99% (Nickelocene), Merck, STREM Chemical
   _ de manganèse : Tris(2,2,6,6-tetramethyl-3,5-heptanedionato)manganese (III),99% Mn(TMHD)3), Merck, STREM Chemical.

### EXEMPLES

### Exemple 1 : Fabrication d'un premier matériau lithié selon l'invention

Le matériau lithié fabriqué dans cet exemple est LiNi_{0.5}Mn_{1.5}O₄ (LNMO) appliqué sur un substrat bidimensionnelle et est obtenu comme indiqué ci-après en utilisant la technique de dépôt par couches atomiques ALD.

Le procédé suivi dans cet exemple comprend quatre principales étapes :
- formation d'un film mince de MnO₂ ;
- formation d'un film mince de NiO ;
- formation d'un film mince lithié en surface ;
- recuit de cristallisation permettant la formation du matériau LNMO.

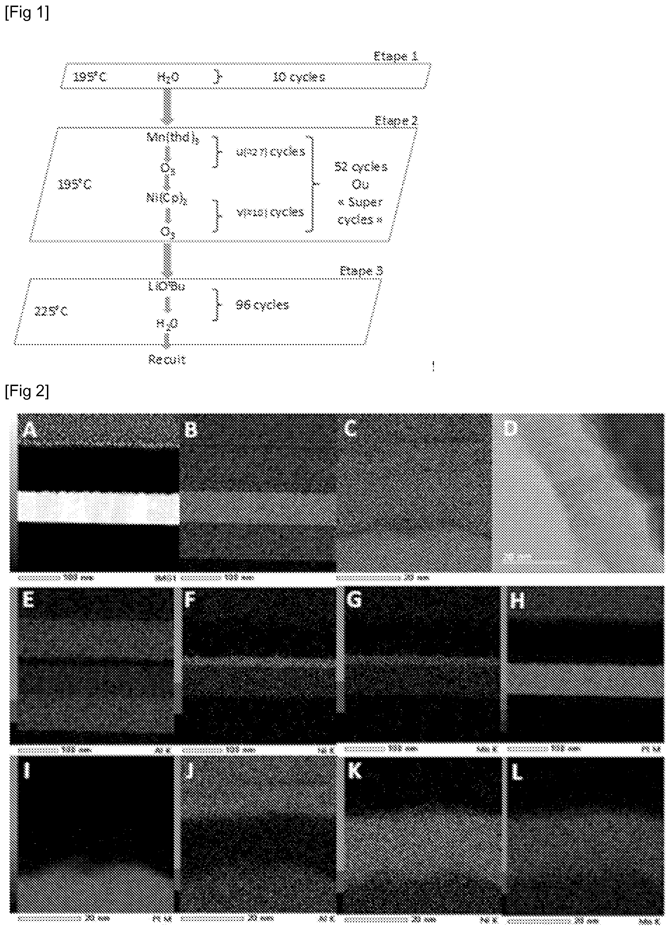

Plus particulièrement, les étapes successives mises en oeuvre dans cet exemple sont les suivantes (illustrées dans la figure 1):
a) placement dans une chambre de réaction d'un substrat en silicium bidimensionnel ;
b1) fonctionnalisation du substrat consistant en une diffusion d'eau déionisée à travers ladite chambre de réaction élevée à une température égale à 195°C ;
b2) purge de ladite chambre de réaction ;
b3) première itération des étapes b1) et b2) pendant 10 fois ;
c1) dépôt par couche atomique d'un précurseur de manganèse (Mn) en pulsant du Mn(thd)s au travers de la chambre de réaction élevée à une température égale à 195°C pour former une couche mince comprenant du Mn à la surface du substrat ;
c2) purge de la chambre de réaction ;
c3) diffusion d'ozone en puisant de l'ozone au travers de la chambre de réaction élevée à une température égale à 195°C pour favoriser la réaction de l'ozone avec la couche mince comprenant du Mn préalablement formée à la surface du substrat à l'issue de l'étape c1) et ainsi former une couche mince de MnO₂ ;
c4) purge de la chambre de réaction ;
c5) deuxième itération des étapes c1) à c4) pendant 27 fois ;
d1) dépôt par couche atomique d'un précurseur de Nickel (Ni) en pulsant du Ni(Cp)₂ au travers de la chambre de réaction élevée à une température égale à 195°C pour former une couche mince comprenant du Ni à la surface de la couche mince de MnO₂ ;
d2) purge de la chambre de réaction ;
d3) diffusion d'ozone en puisant de l'ozone au travers de la chambre de réaction élevée à une température égale à 195 °C pour favoriser la réaction d'ozone avec la couche mince comprenant du Ni préalablement formée à la surface de la couche mince de MnO₂ formée à l'issue de l'étape d1) et ainsi former une couche mince de NiO ;
d4) purge de la chambre de réaction ;
d5) troisième itération des étapes d1) à d4) pendant 10 fois ;
e) quatrième itération des étapes c1) à d4) pendant 52 fois : obtention d'une couche de MnO₂-NiO ;
f1) dépôt par couche atomique d'un précurseur de Li en puisant du LiOtBu au travers de la chambre de réaction élevée à une température environ égale à 225°C pour former une couche mince comprenant du Li à la surface de la couche de MnO₂-NiO ;
f2) purge de la chambre de réaction ;
f3) oxyder la couche mince lithiée en diffusant de l'eau déionisée au travers de la chambre de réaction élevée à une température environ égale à 225°C pour favoriser la réaction de l'eau avec la couche comprenant du Li préalablement formée à la surface de la couche de MnO₂-NiO formée à l'issue de l'étape f1) pour ainsi former une couche mince d'oxyde de lithium ;
f4) purge de la chambre de réaction ;
f5) cinquième itération des étapes f1) à f4) pendant 96 fois ;
g) recuit de cristallisation à une température environ égale à 700°C durant 2h sous air.

En procédant ainsi, on obtient un matériau lithié de LiNi_{0.5}Mn_{1.5}O₄ déposée sur un substrat de silicium et présentant une épaisseur de 100 nm.

II est à noter que les étapes précédemment citées peuvent également être appliqué sur un substrat microstructuré tel que celui décrit dans le document WO2015052412.

### TESTS

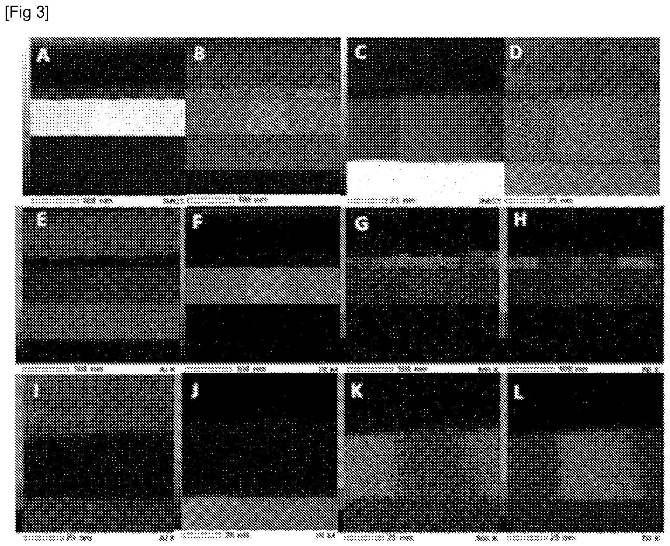

Des analyses par microscopie électronique en transmission (communément désigné par l'acronyme TEM) (voir figures 2 et 3) du matériau lithié obtenu selon l'exemple 1 avant (voir figure 2) et après (voir figure 3) mise en oeuvre de l'étape g) de recuit, ont été réalisées. Le matériau lithié est déposé sur une couche de platine appliquée à partir d'un précurseur de platine et pouvant jouer le rôle d'une couche de collecteur d'une batterie. L'ensemble couche de platine et matériau lithié a été protégé de la découpe par sonde ionique focalisée (communément désigné par l'acronyme anglais FIB) par une couche déposée par ALD de 85 nm d'alumine Al₂O₃ déposé à 300°C sur la couche d'oxyde de lithium du matériau avant recuit et appliquée à partir d'un précurseur d'alumine.

L'analyse du matériau avant recuit est reportée sur la figure 2. Les cellules A, B, C et D illustrent les différentes couches superposées précitées (A et B selon une première échelle, et C et D selon une deuxième échelle comme indiqué sur les figures). Sur les cellules A et B de la figure 2, de bas en haut, on observe une première couche d'alumine, une première couche de platine, une couche de manganèse-nickel, une deuxième couche d'alumine et une deuxième couche de platine. Sur les cellules C et D de la figure 2, de bas en haut, on observe la première couche de platine, la couche de manganèse-nickel, la deuxième couche d'alumine.

Par ailleurs, on remarque qu'il n'y a pas d'espace entre les différentes couches précitées avant recuit. Cette absence d'espace est caractéristique d'une adhérence suffisante entre les couches. Par ailleurs, sur les cellules E à L, on ne voit pas d'interdiffusion de l'alumine, ni de la platine avec le matériau lithié (ici la couche manganèse-nickel car la couche de lithium n'est pas visible sur les photographies, le lithium n'étant pas visible par microscopie électronique de transmission). La couche de platine sur laquelle est appliqué le matériau lithié, dans le cas d'une batterie cette couche pouvant être une couche de collecteur, apparaît rugueuse en surface et l'orientation de ses grains influence l'orientation du matériau lithié déposé au-dessus, le matériau lithié jouant ainsi le rôle de la couche d'électrode positive. On observe également que le manganèse et le nickel sont intimement mélangés formant ainsi une couche homogène et indiquant une bonne répartition des éléments durant le dépôt ALD. Ainsi, la couche mince de Ni, formée après le dépôt de la couche mince de Mn et au-dessus de celle-ci, a diffusé à l'intérieur de la couche de Mn formant la couche manganèse-nickel.

L'analyse du matériau après recuit est quant à elle reportée sur la figure 3. Dans cette figure 3, Sur les cellules A et B, de bas en haut, on observe une première couche d'alumine, une couche de platine, une couche de manganèse-nickel, une deuxième couche d'alumine. Sur les cellules C et D de la figure 2, de bas en haut, on observe la couche de platine, la couche de manganèse-nickel, la deuxième couche d'alumine. Par ailleurs, il est ici possible de distinguer davantage l'influence de l'orientation des grains de la couche de collecteur, de platine, sur l'orientation préférentielle des grains du matériau LNMO. D'une manière générale, on observe une démixtion entre le manganèse et le nickel. En effet, on observe que des zones appauvries en nickel sont enrichies en manganèse et inversement mais dans des proportions différentes. Il est à noter par ailleurs qu'on observe du NiO après le recuit et la formation du matériau LNMO.

Chacune des cellules des figures 2 et 3 correspond à une cartographie chimique des couches empilées sur le substrat de silicium. Les éléments chimiques sont indiqués dans la légende de chaque cellule E à L. Une couleur (ou un niveau de gris) est attribuée à chaque élément chimique. La technique d'analyse utilisée permet également de superposer les couleurs, ou niveau de gris, des différents éléments (voir les cellules B et C de la figure 2, et les cellules B et D de la figure 3).

Dans chacune de ces deux figures (2 et 3), on retrouve deux échelles différentes (une échelle pour les cellules A et B et une autre échelle pour les cellules C et D). Sur les images de cellules, sont représentées l'analyse TEM puis la cartographie chimique avec tous les éléments superposés. Sur les cellules E à L de la figure 2 et E à L de la figure 3, chaque élément chimique (AI, Pt, Ni, Mn) est représenté seul. Cela permet d'avoir accès plus précisément à des informations telles que l'inter-diffusion ou non des éléments entre les couches successives ou bien encore la répartition de ces différents éléments. Sur les cellules G et H, et K et L de la figure 3, une démixtion des éléments manganèse-nickel est observé pour les ratios manganèse-nickel pris en compte sur la figure 1. On peut voir également aucune inter-diffusion entre les couches de platine et d'alumine ou bien encore entre les couches de platine et de manganèse-nickel sur les cellules F à H ou I, K et L de la figure 3.

## Revendications

1. Procédé de fabrication d'un matériau lithié sur un substrat, ledit matériau lithié comprenant plusieurs couches minces et ledit procédé comprenant les étapes suivantes:
a) placement dans une chambre de réaction d'un substrat constitué d'un matériau destiné à être utilisé dans une batterie,
c1) au moins un dépôt par couche atomique d'un précurseur d'un premier métal, choisi parmi le nickel, le manganèse, le cobalt, le chrome, le lanthane, le niobium, le vanadium, le fer, le titane et l'aluminium, à travers ladite chambre de réaction, sur au moins une partie d'une surface dudit substrat,
c2) au moins une purge de ladite chambre de réaction,
c3) au moins une diffusion d'une première espèce oxydante à travers ladite chambre de réaction pour obtenir une couche mince d'un oxyde du premier métal,
c4) au moins une purge de ladite chambre de réaction
f1) au moins un dépôt par couche atomique d'un précurseur de lithium à travers ladite chambre de réaction au-dessus de ladite couche mince d'un oxyde d'un premier métal pour former une couche mince lithiée,
f2) au moins une purge de ladite chambre de réaction,
ledit procédé étant caractérisé en qu'il comprend en outre, après l'étape f2), une étape g) de recuit de cristallisation à une température comprise entre 600 °C et 800 °C pendant une durée comprise entre 1 et 4 h pour obtenir un matériau lithié.

2. Procédé selon la revendication 1, comprenant en outre, entre les étapes a) et c1), au moins une étape b1) de fonctionnalisation du substrat, ladite étape b1) de fonctionnalisation consistant en une diffusion d'eau à travers ladite chambre de réaction et étant suivie d'une étape b2) de purge de ladite chambre de réaction d'eau.

3. Procédé selon la revendication 2, comprenant en outre une étape b3) d'une première itération des étapes b1) et b2) pendant n₁ fois, ladite étape b3) étant réalisée entre l'étape b2) et c1).

4. Procédé selon l'une des revendications 1 à 3, comprenant en outre une étape c5) d'une deuxième itération des étapes c1) à c4) pendant n₂ fois.

5. Procédé selon l'une des revendications 1 à 4, comprenant en outre, entre les étapes c2) et f1) :
- au moins une étape d1) de dépôt par couche atomique d'un précurseur du deuxième de métal, choisi parmi le nickel, le manganèse, le cobalt, le chrome, le lanthane, le titane et l'aluminium, ou d'un précurseur de phosphate, à travers ladite chambre de réaction sur au moins une partie de ladite couche d'un oxyde du premier métal,
- au moins une étape d2) de purge de ladite chambre de réaction,
- au moins une étape d3) de diffusion d'une deuxième espèce oxydante à travers ladite chambre de réaction pour obtenir une couche mince d'un oxyde du deuxième métal ou de phosphate, et
- au moins étape d4) de purge de ladite chambre de réaction.

6. Procédé selon la revendication 5, comprenant en outre une étape d5) d'une troisième itération des étapes d1) à d4) pendant n₃ fois, ladite étape d5) étant réalisée entre l'étape d4) et f1).

7. Procédé selon l'une des revendications 5 ou 6, comprenant en outre une étape e) d'une quatrième itération des étapes c1) à d4) pendant n₄ fois.

8. Procédé selon l'une des revendications 1 à 7, comprenant en outre, entre les étapes f2) et g), au moins une étape f3) d'oxydation forcée de ladite couche mince lithiée, ladite étape f3) d'oxydation forcée consistant en la diffusion d'eau dans ladite chambre de réaction et étant suivie d'une étape f4) de purge de ladite chambre de réaction.

9. Procédé selon la revendication 8, comprenant en outre une étape f5) d'une cinquième itération des étapes f1) à f4) pendant n₅ fois, ladite étape f5) étant réalisée entre l'étape f4) et g).

## Patentansprüche

1. Verfahren zum Herstellen eines lithiierten Materials auf einem Substrat, wobei das lithiierte Material mehrere dünne Schichten umfasst und das Verfahren die folgenden Schritte umfasst:
a) Platzieren eines Substrats aus einem Material, das dazu bestimmt ist, in einer Batterie verwendet zu werden, in eine Reaktionskammer,
c1) mindestens ein Atomlagenabscheiden eines Vorläufers eines ersten Metalls, ausgewählt aus Nickel, Mangan, Kobalt, Chrom, Lanthan, Niob, Vanadium, Eisen, Titan und Aluminium, quer durch die Reaktionskammer auf mindestens einem Teil einer Oberfläche des Substrats,
c2) mindestens ein Spülen der Reaktionskammer,
c3) mindestens ein Diffundieren einer ersten oxidierenden Spezies quer durch die Reaktionskammer, um eine dünne Schicht eines Oxids des ersten Metalls zu erhalten,
c4) mindestens ein Spülen der Reaktionskammer,
f1) mindestens ein Atomlagenabscheiden eines Lithium-Vorläufers quer durch die Reaktionskammer auf der dünnen Schicht eines Oxids eines ersten Metalls, um eine lithiierte dünne Schicht zu bilden,
f2) mindestens ein Spülen der Reaktionskammer,
wobei das Verfahren **dadurch gekennzeichnet ist, dass** es nach Schritt f2) ferner einen Schritt g) des Rekristallisationsglühen bei einer Temperatur zwischen 600 °C und 800 °C über einen Zeitraum zwischen 1 und 4 Stunden umfasst, um ein lithiiertes Material zu erhalten.

2. Verfahren nach Anspruch 1, das zwischen den Schritten a) und c1) ferner mindestens einen Schritt b1) des Funktionalisierens des Substrats umfasst, wobei der Schritt b1) des Funktionalisierens darin besteht, Wasser quer durch die Reaktionskammer zu diffundieren, dem ein Schritt b2) des Spülens der Reaktionskammer mit Wasser folgt.

3. Verfahren nach Anspruch 2, das ferner einen Schritt b3) einer ersten Wiederholung der Schritte b1) und b2) für n₁ Mal umfasst, wobei der Schritt b3) zwischen Schritt b2) und c1) ausgeführt wird.

4. Verfahren nach einem der Ansprüche 1 bis 3, das ferner einen Schritt c5) einer zweiten Wiederholung der Schritte c1) bis c4) für n₂ Mal umfasst.

5. Verfahren nach einem der Ansprüche 1 bis 4, das zwischen den Schritten c2) und f1) ferner Folgendes umfasst:
- mindestens einen Schritt d1) des Atomlagenabscheiden eines Vorläufers des zweiten Metalls, ausgewählt aus Nickel, Mangan, Kobalt, Chrom, Lanthan, Titan und Aluminium, oder eines Phosphatvorläufers quer durch die Reaktionskammer auf mindestens einem Teil der Schicht aus einem Oxid des ersten Metalls,
- mindestens einen Schritt d2) des Spülens der Reaktionskammer,
- mindestens einen Schritt d3) des Diffundierens einer zweiten oxidierenden Spezies quer durch die Reaktionskammer, um eine dünne Schicht eines Oxids des zweiten Metalls oder von Phosphat zu erhalten, und
- mindestens einen Schritt d4) des Spülens der Reaktionskammer.

6. Verfahren nach Anspruch 5, das ferner einen Schritt d5) einer dritten Wiederholung der Schritte d1) bis d4) für n₃ Mal umfasst, wobei der Schritt d5) zwischen den Schritten d4) und f1) ausgeführt wird.

7. Verfahren nach einem der Ansprüche 5 oder 6, das ferner einen Schritt e) einer vierten Wiederholung der Schritte c1) bis d4) für n₄ Mal umfasst.

8. Verfahren nach einem der Ansprüche 1 bis 7, das zwischen den Schritten f2) und g) ferner mindestens einen Schritt f3) des erzwungenen Oxidierens der lithiierten dünnen Schicht umfasst, wobei der Schritt f3) des erzwungenen Oxidierens aus dem Diffundieren von Wasser in die Reaktionskammer besteht, dem ein Schritt f4) des Spülens der Reaktionskammer folgt.

9. Verfahren nach Anspruch 8, das ferner einen Schritt f5) einer fünften Wiederholung der Schritte f1) bis f4) für n₅ Mal umfasst, wobei der Schritt f5) zwischen den Schritten f4) und g) ausgeführt wird.

## Claims

1. A method for manufacturing a lithiated material on a substrate, said lithiated material comprising multiple thin layers and said method comprising the following steps:
a) placing a substrate made of a material intended to be used in a battery in a reaction chamber,
c1) at least one atomic layer deposition of a precursor of a first metal, selected from among nickel, manganese, cobalt, chromium, lanthanum, niobium, vanadium, iron, titanium and aluminum, through said reaction chamber, on at least part of a surface of said substrate,
c2) at least one purge of said reaction chamber,
c3) at least one diffusion of a first oxidizing species through said reaction chamber to obtain a thin layer of an oxide of the first metal,
c4) at least one purge of said reaction chamber
f1) at least one atomic layer deposition of a lithium precursor through said reaction chamber on top of said thin layer of an oxide of a first metal to form a lithiated thin layer,
f2) at least one purge of said reaction chamber,
said method being **characterized in that** it further comprises, after step f2), a crystallization annealing step g) at a temperature of between 600°C and 800°C for a period of between 1 and 4 hours to obtain a lithiated material.

2. The method as claimed in claim 1, further comprising, between steps a) and c1), at least one step b1) of functionalizing the substrate, said functionalizing step b1) consisting in diffusing water through said reaction chamber and being followed by a step b2) of purging said reaction chamber of water.

3. The method as claimed in claim 2, further comprising a step b3) of a first iteration of the steps b1) and b2) n₁ times, said step b3) being carried out between step b2) and c1).

4. The method as claimed in one of claims 1 to 3, further comprising a step c5) of a second iteration of steps c1) to c4) n₂ times.

5. The method as claimed in one of claims 1 to 4, further comprising, between steps c2) and f1):
- at least one step d1) of atomic layer deposition of a precursor of the second metal, selected from among nickel, manganese, cobalt, chromium, lanthanum, titanium and aluminum, or a phosphate precursor, through said reaction chamber on at least part of said layer of an oxide of the first metal,
- at least one step d2) of purging said reaction chamber,
- at least one step d3) of diffusing a second oxidizing species through said reaction chamber to obtain a thin layer of an oxide of the second metal or of phosphate, and
- at least one step d4) of purging said reaction chamber.

6. The method as claimed in claim 5, further comprising a step d5) of a third iteration of steps d1) to d4) n₃ times, said step d5) being carried out between steps d4) and f1).

7. The method as claimed in one of claims 5 and 6, further comprising a step e) of a fourth iteration of steps c1) to d4) n₄ times.

8. The method as claimed in one of claims 1 to 7, further comprising, between steps f2) and g), at least one step f3) of forced oxidation of said lithiated thin layer, said forced oxidation step f3) consisting of the diffusion of water into said reaction chamber and being followed by a step f4) of purging said reaction chamber.

9. The method as claimed in claim 8, further comprising a step f5) of a fifth iteration of steps f1) to f4) n₅ times, said step f5) being carried out between steps f4) and g).
